# EUROPEAN PATENT APPLICATION

(11) **EP 4 577 007 A1**
(43) Date of publication of application: **25.06.2025**
(21) Application number: 24222000.2
(22) Date of filing: 20.12.2024
(51) Int. Cl.: H10H 29/01, H10H 29/80, H10H 29/85

(54) **LIGHT-EMITTING DEVICE, ELECTRONIC EQUIPMENT, AND MANUFACTURING METHOD FOR LIGHT-EMITTING DEVICE**

(30) Priority: 22.12.2023 JP 2023216986
(71) Applicant: Seiko Epson Corporation, Tokyo 160-8801 (JP)
(72) Inventor: TERAO, Shinji, Suwa-shi, 392-8502 (JP)
(74) Representative: Lewis Silkin LLP

(57) **Abstract**

A light-emitting device including a substrate, a first pad provided at the substrate, a first electrode provided at the first pad, a first laminate provided at the first electrode, an insulation layer provided at a side surface of the first laminate, a first metal layer provided at the insulation layer, a second pad provided at the substrate and separated from the first pad, a conductive layer provided at the second pad, a second laminate provided at the conductive layer, a second metal layer provided at a side surface of the second laminate, and a second electrode provided at sides of the first laminate and the second laminate opposite to the substrate and electrically coupled to the second pad via the second metal layer, in which the first laminate includes a first semiconductor layer of a first conductivity type, a second semiconductor layer of a second conductivity type, and a first quantum well layer, and the second laminate includes a third semiconductor layer of the first conductivity type, a fourth semiconductor layer of the second conductivity type, and a second quantum well layer.

## Description

The present application is based on, and claims priority from JP Application Serial Number 2023-216986, filed December 22, 2023, the disclosure of which is hereby incorporated by reference herein in its entirety.

### BACKGROUND

### 1. Technical Field

The present disclosure relates to a light-emitting device, electronic equipment, and a manufacturing method for a light-emitting device.

### 2. Related Art

A light-emitting element such as a light emitting diode (LED) is applied to a light source of a display device and the like.

For example, JP-A-2015-195244 discloses a semiconductor unit including a light-emitting element including a semiconductor layer configured by laminating a first conductivity type layer, an active layer, and a second conductivity type layer in order from the bottom, a first electrode provided at a lower surface of the first conductivity type layer, and a second electrode provided at an upper surface of the second conductivity type layer. The first electrode is coupled to a terminal electrode provided at a substrate via a plating layer. The second electrode is coupled to a terminal electrode provided at the substrate via a bump and a coupling portion.

In the semiconductor unit described in JP-A-2015-195244, since a bump and a coupling portion are used to electrically couple the second electrode and the terminal electrode, the manufacturing process becomes complicated.

### SUMMARY

One aspect of a light-emitting device according to the present disclosure includes
a substrate,
a first pad provided at the substrate,
a first electrode provided at the first pad,
a first laminate provided at the first electrode,
an insulation layer provided at a side surface of the first laminate,
a first metal layer provided at the insulation layer,
a second pad provided at the substrate and separated from the first pad,
a conductive layer provided at the second pad,
a second laminate provided at the conductive layer,
a second metal layer provided at a side surface of the second laminate, and
a second electrode provided at sides of the first laminate and the second laminate opposite to the substrate and electrically coupled to the second pad via the second metal layer, in which
the first laminate includes
a first semiconductor layer of a first conductivity type,
a second semiconductor layer of a second conductivity type different from the first conductivity type provided between the first semiconductor layer and the second electrode, and
a first quantum well layer provided between the first semiconductor layer and the second semiconductor layer, and
the second laminate includes
a third semiconductor layer of the first conductivity type,
a fourth semiconductor layer of the second conductivity type provided between the third semiconductor layer and the second electrode, and
a second quantum well layer provided between the third semiconductor layer and the fourth semiconductor layer.

One aspect of electronic equipment according to the present disclosure includes
one aspect of the light-emitting device.

One aspect of a manufacturing method for a light-emitting device according to the present disclosure includes:
forming a first laminate and a second laminate separated from each other on a first substrate,
forming a first electrode on the first laminate and forming a conductive layer on the second laminate,
forming an insulation layer on a side surface of the first laminate,
forming a first metal layer on the insulation layer and forming a second metal layer on a side surface of the second laminate,
bonding a structure including the first substrate, the first laminate, the second laminate, the first electrode, the conductive layer, the insulation layer, the first metal layer, and the second metal layer to a second substrate provided with a first pad and a second pad separated from each other such that the first electrode opposes the first pad and the conductive layer opposes the second pad,
removing the first substrate to expose the first laminate and the second laminate, and
forming a second electrode on the first laminate and the second laminate, in which
the first laminate includes
a first semiconductor layer of a first conductivity type,
a second semiconductor layer of a second conductivity type different from the first conductivity type provided between the first semiconductor layer and the second electrode, and
a first quantum well layer between the first semiconductor layer and the second semiconductor layer, and
the second laminate includes
a third semiconductor layer of the first conductivity type,
a fourth semiconductor layer of the second conductivity type provided between the third semiconductor layer and the second electrode, and
a second quantum well layer between the third semiconductor layer and the fourth semiconductor layer.

### BRIEF DESCRIPTION OF THE DRAWINGS

FIG. 1 is a cross-sectional view schematically illustrating a light-emitting device according to the present embodiment.
FIG. 2 is a plan view schematically illustrating the light-emitting device according to the present embodiment.
FIG. 3 is a cross-sectional view schematically illustrating the light-emitting device according to the present embodiment.
FIG. 4 is a cross-sectional view schematically illustrating a manufacturing process for the light-emitting device according to the present embodiment.
FIG. 5 is a cross-sectional view schematically illustrating the manufacturing process for the light-emitting device according to the present embodiment.
FIG. 6 is a cross-sectional view schematically illustrating the manufacturing process for the light-emitting device according to the present embodiment.
FIG. 7 is a cross-sectional view schematically illustrating the manufacturing process for the light-emitting device according to the present embodiment.
FIG. 8 is a cross-sectional view schematically illustrating the manufacturing process for the light-emitting device according to the present embodiment.
FIG. 9 is a cross-sectional view schematically illustrating the manufacturing process for the light-emitting device according to the present embodiment.
FIG. 10 is a cross-sectional view schematically illustrating the manufacturing process for the light-emitting device according to the present embodiment.
FIG. 11 is a cross-sectional view schematically illustrating the manufacturing process for the light-emitting device according to the present embodiment.
FIG. 12 is a cross-sectional view schematically illustrating the manufacturing process for the light-emitting device according to the present embodiment.
FIG. 13 is a cross-sectional view schematically illustrating the manufacturing process for the light-emitting device according to the present embodiment.
FIG. 14 is a cross-sectional view schematically illustrating the manufacturing process for the light-emitting device according to the present embodiment.
FIG. 15 is a plan view schematically illustrating a light-emitting device according to a modification example of the present embodiment.
FIG. 16 is a view schematically illustrating a projector according to the present embodiment.
FIG. 17 is a plan view schematically illustrating a display according to the present embodiment.
FIG. 18 is a cross-sectional view schematically illustrating the display according to the present embodiment.
FIG. 19 is a perspective view schematically illustrating a head-mounted display according to the present embodiment.
FIG. 20 is a view schematically illustrating an image formation device and a light guide device of the head-mounted display according to the present embodiment.

### DESCRIPTION OF EMBODIMENTS

A preferred embodiment of the present disclosure will be described below in detail with reference to the drawings. Note that the embodiment described below does not unduly limit the content of the present disclosure described in the claims. Not all the configurations described below are essential constituent elements of the present disclosure.

### 1. Light-Emitting Device

### 1.1. Configuration

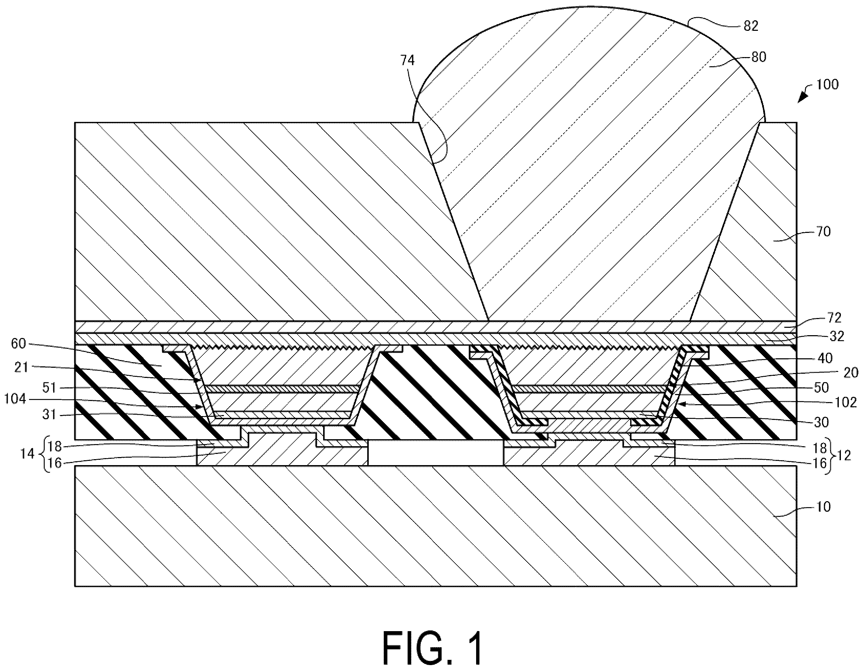

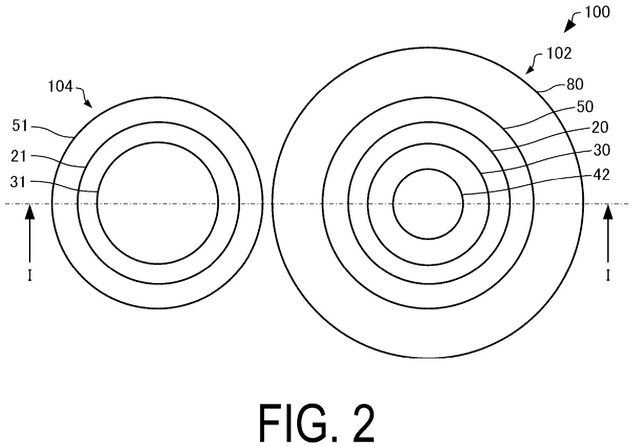

First, a light-emitting device according to the present embodiment will be described with reference to the drawings. FIG. 1 is a cross-sectional view schematically illustrating a light-emitting device 100 according to the present embodiment. FIG. 2 is a plan view schematically illustrating the light-emitting device 100 according to the present embodiment. FIG. 1 is a cross-sectional view taken along line I-I in FIG. 2.

As illustrated in FIGS. 1 and 2, the light-emitting device 100 includes, for example, a drive substrate 10, a first pad 12, a second pad 14, a light-emitting element 102, a coupling portion 104, a protective layer 60, a third metal layer 70, and a translucent member 80.

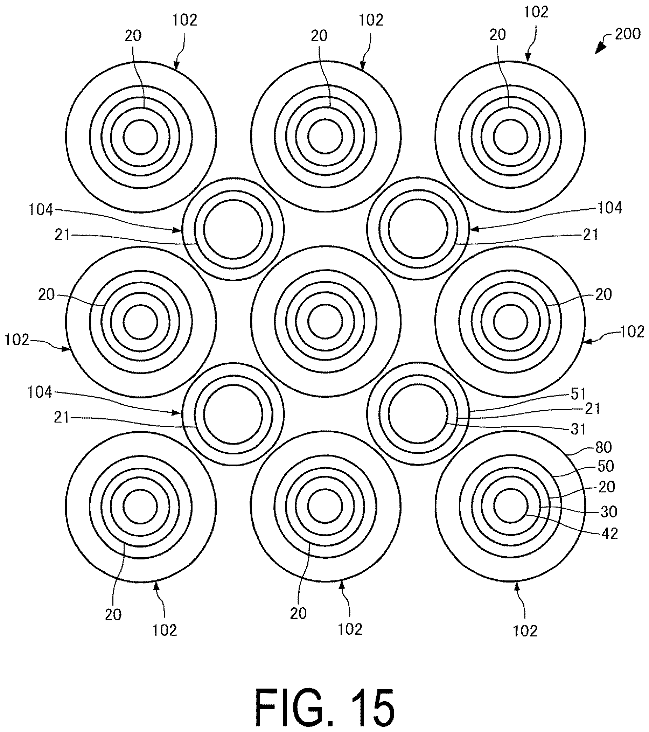

For convenience, FIG. 2 omits illustration of members other than a first laminate 20, a first electrode 30, a first contact hole 42, and a first metal layer 50 of the light-emitting element 102, and a second laminate 21, a conductive layer 31, and a second metal layer 51 of the coupling portion 104, and the translucent member 80. This is similar to FIG. 15 described later.

The drive substrate 10 is, for example, a silicon substrate. The drive substrate 10 is provided with a drive circuit for driving the light-emitting element 102, for example. The drive circuit includes, for example, an integrated circuit (IC).

As illustrated in FIG. 1, the first pad 12 and the second pad 14 are provided on the drive substrate 10. The first pad 12 and the second pad 14 are separated from each other. The first pad 12 and the second pad 14 may constitute the drive circuit. The first pad 12 and the second pad 14 include, for example, a first layer 16 and a second layer 18. The first layer 16 is provided at the drive substrate 10. As the first layer 16, for example, one in which a Ti layer and a Pt layer are laminated in this order from the drive substrate 10 side is used. The second layer 18 is provided on the first layer 16. The second layer 18 is, for example, an Au layer, an Al layer, or a Cu layer.

The light-emitting element 102 is provided at the first pad 12. The light-emitting element 102 is junction-down mounted, for example. The light-emitting element 102 is, for example, an LED. The light-emitting element 102 includes, for example, the first laminate 20, the first electrode 30, a second electrode 32, an insulation layer 40, and the first metal layer 50.

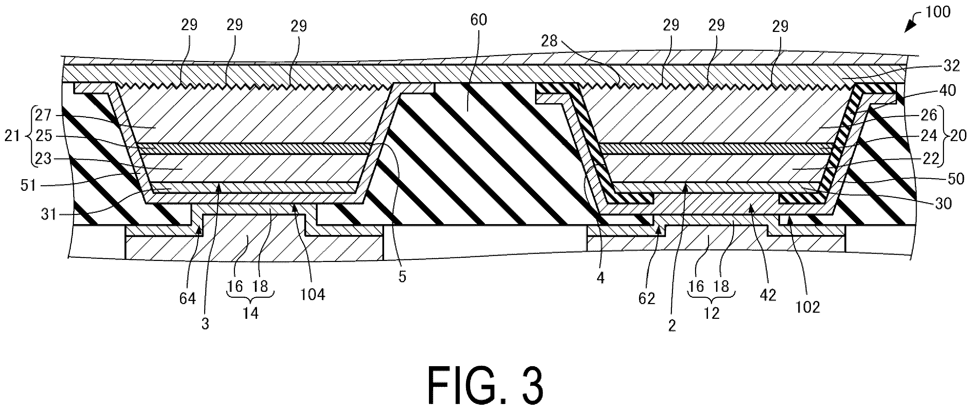

The first laminate 20 is provided between the first electrode 30 and the second electrode 32. The first laminate 20 is provided at the first electrode 30. Here, FIG. 3 is an enlarged view of FIG. 1 illustrating the vicinity of the first laminate 20 and the second laminate 21. As illustrated in FIG. 3, the first laminate 20 includes a first tapered portion 2 having a tapered shape whose width increases from the first electrode 30 side toward the second electrode 32 side. The width of the first tapered portion 2 gradually increases from the first electrode 30 side toward the second electrode 32 side. In the illustrated example, the shape of the first tapered portion 2 is a trapezoidal shape. The width is a size in a direction orthogonal to a lamination direction of a first semiconductor layer 22 and a first quantum well layer 24 of a first laminate 20 (hereinafter, also simply called "lamination direction"). A first side surface 4 of the first tapered portion 2 is inclined with respect to the lamination direction. The first side surface 4 of the first tapered portion 2 constitutes a side surface of the first laminate 20.

The first laminate 20 includes the first semiconductor layer 22, the first quantum well layer 24, and a second semiconductor layer 26. The first semiconductor layer 22, the first quantum well layer 24, and the second semiconductor layer 26 constitute the first tapered portion 2. The first semiconductor layer 22, the first quantum well layer 24, and the second semiconductor layer 26 are, for example, group III nitride semiconductors and have a wurtzite-type crystal structure.

The first semiconductor layer 22 is provided on the first electrode 30. The first semiconductor layer 22 is provided between the first electrode 30 and the first quantum well layer 24. The first semiconductor layer 22 has a first conductivity type. The first semiconductor layer 22 is a p-type GaN layer doped with Mg, for example.

The first quantum well layer 24 is provided on the first semiconductor layer 22. The first quantum well layer 24 is provided between the first semiconductor layer 22 and the second semiconductor layer 26. The first quantum well layer 24 has an i-type conductivity type not intentionally doped with impurities. The first quantum well layer 24 generates light by injecting a current. The first quantum well layer 24 includes, for example, a well layer and a barrier layer. The well layer and the barrier layer are i-type semiconductor layers. The well layer is, for example, an InGaN layer. The barrier layer is, for example, a GaN layer. The first quantum well layer 24 has a multiple quantum well (MQW) structure including the well layer and the barrier layer.

The numbers of well layers and barrier layers constituting the first quantum well layer 24 are not particularly limited. For example, only one layer of the well layer may be provided, and in this case, the first quantum well layer 24 has a single quantum well (SQW) structure.

The second semiconductor layer 26 is provided on the first quantum well layer 24. The second semiconductor layer 26 is provided between the first quantum well layer 24 and the second electrode 32. The second semiconductor layer 26 is provided between the first semiconductor layer 22 and the second electrode 32. In the illustrated example, the size in the lamination direction of the second semiconductor layer 26 is larger than the size in the lamination direction of the first semiconductor layer 22. The second semiconductor layer 26 has a second conductivity type different from the first conductivity type. The second semiconductor layer 26 is an n-type GaN layer doped with Si, for example.

The second semiconductor layer 26 includes a contact surface 28 in contact with the second electrode 32. The contact surface 28 is provided with, for example, a plurality of protrusions 29. The plurality of protrusions 29 are provided, for example, cyclically. The height of the protrusion 29 is 400 nm or more, for example. An interval between tip ends of the protrusions 29 adjacent to each other is 230 nm or less, for example. The plurality of protrusions 29 may constitute a moth-eye structure. In the illustrated example, the first laminate 20 is configured by the first tapered portion 2 and the plurality of protrusions 29. The plurality of protrusions 29 can gently change the refractive index at an interface between the second semiconductor layer 26 and the second electrode 32 in the direction from the second semiconductor layer 26 toward the second electrode 32. This can reduce light reflected at the interface between the second semiconductor layer 26 and the second electrode 32. Although not illustrated, the plurality of protrusions 29 may be randomly provided.

In the light-emitting element 102, the first semiconductor layer 22 of the p-type, the first quantum well layer 24 of the i-type, and the second semiconductor layer 26 of the n-type constitute a pin diode. In the light-emitting element 102, when a forward bias voltage of a pin diode is applied between the first electrode 30 and the second electrode 32, a current is injected into the first quantum well layer 24, and recombination of electrons and holes occurs in the first quantum well layer 24. By this recombination, the first quantum well layer 24 generates light.

The first electrode 30 is provided at the first pad 12. The first electrode 30 is provided between the drive substrate 10 and the first semiconductor layer 22. The first electrode 30 is electrically coupled to the first semiconductor layer 22. The first semiconductor layer 22 may be in ohmic contact with the first electrode 30. As the first electrode 30, for example, one in which a Pd layer, a Pt layer, and an Au layer are laminated in this order from the first semiconductor layer 22 side is used.

The first electrode 30 is one electrode for injecting a current into the first quantum well layer 24. The first electrode 30 is applied with a potential of a data signal, for example. The first electrode 30 reflects, toward the second electrode 32, light generated in the first quantum well layer 24.

The second electrode 32 is provided at the side of the first laminate 20 and the second laminate 21 opposite to the drive substrate 10. The second electrode 32 is provided on the second semiconductor layer 26 of the first laminate 20 and on a fourth semiconductor layer 27 of the second laminate 21. The second electrode 32 is arranged to oppose the drive substrate 10. The second electrode 32 is electrically coupled to the second semiconductor layer 26. The second semiconductor layer 26 may be in ohmic contact with the second electrode 32. The second electrode 32 has translucency. Specifically, the second electrode 32 transmits light generated in the first quantum well layer 24. The light generated in the first quantum well layer 24 is emitted from the second electrode 32 side. The material of the second electrode 32 is indium tin oxide (ITO), for example.

The second electrode 32 is the other electrode for injecting a current into the first quantum well layer 24. The second electrode 32 is applied with a constant potential, for example. The second electrode 32 may be applied with a ground potential.

The insulation layer 40 is provided at the first side surface 4 of the first laminate 20. The insulation layer 40 is provided at the entire surface of the first side surface 4. In the illustrated example, the insulation layer 40 is further provided at a part of a lower surface of the second electrode 32 and a part of a lower surface of the first electrode 30. The insulation layer 40 surrounds the first laminate 20 in plan view. In other words, the insulation layer 40 surrounds the first laminate 20 as viewed from the lamination direction. The insulation layer 40 has translucency. Specifically, the insulation layer 40 transmits light generated in the first quantum well layer 24. The insulation layer 40 is a SiO₂ layer, for example.

The first contact hole 42 is formed in the insulation layer 40. In the example illustrated in FIG. 2, the planar shape of the first contact hole 42 is a circular shape. The first contact hole 42 overlaps the first electrode 30 in plan view.

As illustrated in FIG. 3, the first metal layer 50 is provided at the insulation layer 40. The first metal layer 50 is provided at the insulation layer 40 from a part provided at the lower surface of the first electrode 30 to a part provided at the lower surface of the second electrode 32. The first metal layer 50 is further provided in the first contact hole 42. The first metal layer 50 is electrically separated from the second electrode 32 by the insulation layer 40. The first metal layer 50 surrounds the first laminate 20 in plan view, for example.

The first metal layer 50 is coupled to the first electrode 30. The first metal layer 50 is further coupled to the first pad 12. The first metal layer 50 may be eutectically bonded to the first pad 12. The first metal layer 50 may be Au-Au bonded, Al-Al bonded, or Cu-Cu bonded to the first pad 12. The first pad 12 is electrically coupled to the first electrode 30 via the first metal layer 50. The first metal layer 50 is, for example, an Au layer, an Al layer, or a Cu layer. The first metal layer 50 reflects, toward the first laminate 20 side, light generated in the first quantum well layer 24.

The coupling portion 104 is provided on the second pad 14. The coupling portion 104 is provided between the second pad 14 and the second electrode 32. The coupling portion 104 couples the second pad 14 and the second electrode 32. The coupling portion 104 includes, for example, the second laminate 21, the conductive layer 31, and the second metal layer 51.

The second laminate 21 is provided between the conductive layer 31 and the second electrode 32. The second laminate 21 is provided on the conductive layer 31. The second laminate 21 is separated from the first laminate 20. The shape of the second laminate 21 is, for example, the same as the shape of the first laminate 20. The second laminate 21 includes a second tapered portion 3. A second side surface 5 of the second tapered portion 3 constitutes a side surface of the second laminate 21.

The second laminate 21 includes a third semiconductor layer 23, a second quantum well layer 25, and the fourth semiconductor layer 27. The third semiconductor layer 23, the second quantum well layer 25, and the fourth semiconductor layer 27 constitute the second tapered portion 3.

The third semiconductor layer 23 is provided on the conductive layer 31. The third semiconductor layer 23 is provided between the conductive layer 31 and the second quantum well layer 25. The thickness of the third semiconductor layer 23 is the same as the thickness of the first semiconductor layer 22, for example. The material of the third semiconductor layer 23 is the same as the material of the first semiconductor layer 22, for example.

The second quantum well layer 25 is provided on the third semiconductor layer 23. The second quantum well layer 25 is provided between the third semiconductor layer 23 and the fourth semiconductor layer 27. The thickness of the second quantum well layer 25 is the same as the thickness of the first quantum well layer 24, for example. The material of the second quantum well layer 25 is the same as the material of the first quantum well layer 24, for example. In the coupling portion 104, the third semiconductor layer 23 and the fourth semiconductor layer 27 are short-circuited by the second metal layer 51. Therefore, light is not generated in the second quantum well layer 25.

The fourth semiconductor layer 27 is provided on the second quantum well layer 25. The fourth semiconductor layer 27 is provided between the second quantum well layer 25 and the second electrode 32. The fourth semiconductor layer 27 is provided between the third semiconductor layer 23 and the second electrode 32. The thickness of the fourth semiconductor layer 27 is the same as the thickness of the second semiconductor layer 26, for example. The material of the fourth semiconductor layer 27 is the same as the material of the second semiconductor layer 26, for example. The fourth semiconductor layer 27 has a plurality of protrusions 29, for example.

The conductive layer 31 is provided on the second pad 14. The conductive layer 31 is provided between the drive substrate 10 and the third semiconductor layer 23. The thickness of the conductive layer 31 is the same as the thickness of the first electrode 30, for example. The material of the conductive layer 31 is the same as the material of the first electrode 30, for example.

The second metal layer 51 is provided at the second side surface 5 of the second laminate 21. The second metal layer 51 is provided at the entire surface of the second side surface 5. In the illustrated example, the second metal layer 51 is further provided at a part of the lower surface of the second electrode 32 and at the entire surface of the lower surface of the conductive layer 31. The second metal layer 51 surrounds the second laminate 21 in plan view, for example.

The second metal layer 51 is coupled to the conductive layer 31. The second metal layer 51 is further coupled to the second pad 14. The second metal layer 51 may be eutectically bonded to the second pad 14. The second metal layer 51 may be Au-Au bonded, Al-Al bonded, or Cu-Cu bonded to the second pad 14. The second metal layer 51 is further coupled to the second electrode 32. The thickness of the second metal layer 51 is the same as the thickness of the first metal layer 50, for example. The material of the second metal layer 51 is the same as the material of the first metal layer 50, for example. The second electrode 32 is electrically coupled to the second pad 14 via the second metal layer 51. The second electrode 32 is provided at the side of the first laminate 20 and the second laminate 21 opposite to the drive substrate 10.

Note that the second metal layer 51 needs not be provided at the entire surface of the second side surface 5 of the second laminate 21 as long as the third semiconductor layer 23 and the fourth semiconductor layer 27 can be short-circuited. Although not illustrated, the second metal layer 51 may be provided at only in a partial region including the side surface of the second quantum well layer 25. In this case, the second electrode 32 is electrically coupled to the second pad 14 via the fourth semiconductor layer 27, the second metal layer 51, the third semiconductor layer 23, and the conductive layer 31.

However, in consideration of a voltage drop, as illustrated in FIG. 3, the second metal layer 51 is preferably provided at a part of the lower surface of the second electrode 32, the entire surface of the second side surface 5, and the entire surface of the lower surface of the conductive layer 31, and electrically couples the second pad 14 and the second electrode 32.

As illustrated in FIG. 1, the protective layer 60 is provided between the drive substrate 10 and the second electrode 32. The protective layer 60 surrounds the first laminate 20 and the second laminate 21 in plan view, for example. The protective layer 60 is provided between the first laminate 20 and the second laminate 21. In the illustrated example, the protective layer 60 is separated from the drive substrate 10 via a void. The protective layer 60 is a SiO₂ layer, for example. The protective layer 60 protects the first laminate 20 from foreign matters and the like. The protective layer 60 can further reduce the possibility of disconnection of the second electrode 32.

As illustrated in FIG. 3, a second contact hole 62 and a third contact hole 64 are formed in the protective layer 60. The second contact hole 62 overlaps the first metal layer 50 in plan view. In the illustrated example, the second contact hole 62 is provided with the second layer 18 of the first pad 12. The third contact hole 64 overlaps the second metal layer 51 in plan view. In the illustrated example, the third contact hole 64 is provided with the second layer 18 of the second pad 14.

As illustrated in FIG. 1, the third metal layer 70 is provided at a side of the second electrode 32 opposite to the drive substrate 10. In the illustrated example, the third metal layer 70 is provided on the second electrode 32 via an adhesion layer 72. The adhesion layer 72 is, for example, a TiN layer. The adhesion layer 72 improves adhesion between the second electrode 32 and the third metal layer 70. The third metal layer 70 does not overlap the first laminate 20, for example, in plan view. The third metal layer 70 is, for example, an Al layer.

The third metal layer 70 includes a reflection surface 74. The reflection surface 74 is a side surface of the third metal layer 70. In the illustrated example, the reflection surface 74 is positioned on an extension of the first side surface 4 of the first tapered portion 2. The inclination of the reflection surface 74 with respect to the lamination direction is the same as the inclination of the first side surface 4, for example, with respect to the lamination direction. The reflection surface 74 reflects, toward the translucent member 80 side, light generated in the first quantum well layer 24.

The translucent member 80 is provided at the side of the second electrode 32 opposite to the drive substrate 10. The translucent member 80 is provided on the adhesion layer 72. The translucent member 80 is in contact with the reflection surface 74 of the third metal layer 70. The third metal layer 70 surrounds the translucent member 80 in plan view, for example. The material of the translucent member 80 is SiON, for example. The translucent member 80 transmits light transmitted through the second electrode 32. The translucent member 80 transmits light reflected by the reflection surface 74.

The translucent member 80 includes an emission surface 82 that emits light generated in the first quantum well layer 24. The emission surface 82 is a surface on the side of the translucent member 80 opposite to the drive substrate 10. The emission surface 82 is, for example, a curved surface. In the illustrated example, the emission surface 82 is a convex surface.

Although an example in which the first conductivity type is the p-type and the second conductivity type is the n-type has been described above, the first conductivity type may be the n-type and the second conductivity type may be the p-type.

Although an example in which a void is present between the drive substrate 10 and the protective layer 60 has been described above, the drive substrate 10 and the protective layer 60 may be in contact with each other. In this case, the first pad 12 and the second pad 14 may be embedded in the drive substrate 10. The first pad 12 and the light-emitting element 102 may be coupled to each other by hybrid bonding. The second pad 14 and the coupling portion 104 may be coupled to each other by hybrid bonding.

Although an example in which the first contact hole 42 is provided with the first metal layer 50 has been described above, the first contact hole 42 may be provided with not the first metal layer 50 but the first pad 12 as long as the first pad 12 is electrically coupled to the first electrode 30.

Although the InGaN-based first quantum well layer 24 has been described above, various material systems that can emit light by injecting a current in accordance with the wavelength of light to be emitted can be used as the first quantum well layer 24. For example, semiconductor materials such as an AlGaN based, AlGaAs based, InGaAs based, InGaAsP based, InP based, GaP based, and AlGaP based materials can be used.

### 1.2. Operations and Effects

The light-emitting device 100 includes the drive substrate 10, the first pad 12 provided at the drive substrate 10, the first electrode 30 provided at the first pad 12, the first laminate 20 provided at the first electrode 30, the insulation layer 40 provided at the first side surface 4 of the first laminate 20, and the first metal layer 50 provided at the insulation layer 40. The light-emitting device 100 further includes the second pad 14 provided at the drive substrate 10 and separated from the first pad 12, the conductive layer 31 provided at the second pad 14, the second laminate 21 provided at the conductive layer 31, and the second metal layer 51 provided at the second side surface 5 of the second laminate 21. Furthermore, the light-emitting device 100 includes the second electrode 32 provided at the side of the first laminate 20 and the second laminate 21 opposite to the drive substrate 10 and electrically coupled to the second pad 14 via the second metal layer 51.

Therefore, in the light-emitting device 100, the first laminate 20 and the second laminate 21 can be formed in the same process, the first electrode 30 and the conductive layer 31 can be formed in the same process, and the first metal layer 50 and the second metal layer 51 can be formed in the same process. Due to this, it is not necessary to add a separate manufacturing process for electrical coupling between the second electrode 32 and the second pad 14. Therefore, the manufacturing process can be shortened as compared with the case where, for example, the second electrode and the second pad are electrically coupled by a bump or the like. Furthermore, the manufacturing cost can be reduced.

In the light-emitting device 100, the second electrode 32 is applied with a constant potential. Therefore, in the light-emitting device 100, the amount of current injected into the first quantum well layer 24 can be adjusted by the potential of the first electrode 30.

In the light-emitting device 100, the first laminate 20 includes the first tapered portion 2 whose width increases from the first electrode 30 side toward the second electrode 32 side. Therefore, the light-emitting device 100 can reflect, toward the second electrode 32 side, light generated in the first quantum well layer 24 on the first side surface 4 of the first tapered portion 2.

The light-emitting device 100 includes the third metal layer 70 provided at the side of the second electrode 32 opposite to the drive substrate 10 and having the reflection surface 74 that reflects light generated in the first quantum well layer 24, and the reflection surface 74 is positioned on the extension of the first side surface 4 of the first tapered portion 2. Therefore, the light-emitting device 100 can emit light having a narrower radiation angle while suppressing light transmitted through the second electrode 32 from leaking to the outside.

The light-emitting device 100 includes the translucent member 80 provided at the side of the second electrode 32 opposite to the first laminate 20 and in contact with the reflection surface 74. Therefore, the light-emitting device 100 can more reliably reflect, toward the translucent member 80 side, light transmitted through the translucent member 80 and incident on the reflection surface 74 on the reflection surface 74.

In the light-emitting device 100, the emission surface 82 on the side of the translucent member 80 opposite to the drive substrate 10 is a curved surface. Therefore, in the light-emitting device 100, the translucent member 80 can function as a lens.

In the light-emitting device 100, the insulation layer 40 has translucency. Therefore, in the light-emitting device 100, even if light generated in the first quantum well layer 24 is transmitted through the insulation layer 40 having translucency, the light transmitted through the insulation layer 40 can be reflected toward the first laminate 20 side by the first metal layer 50.

### 2. Manufacturing Method for Light-Emitting Device

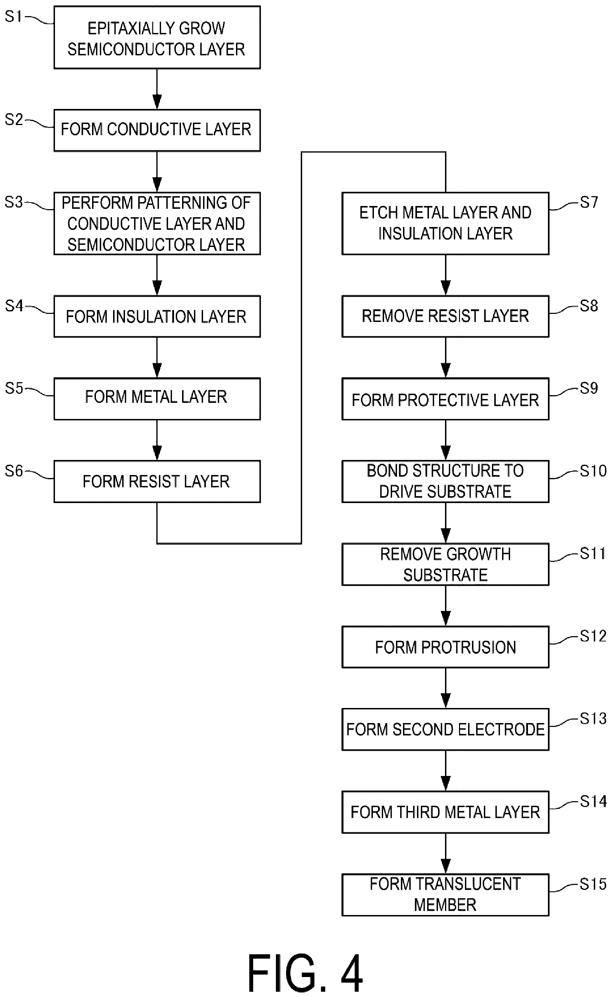

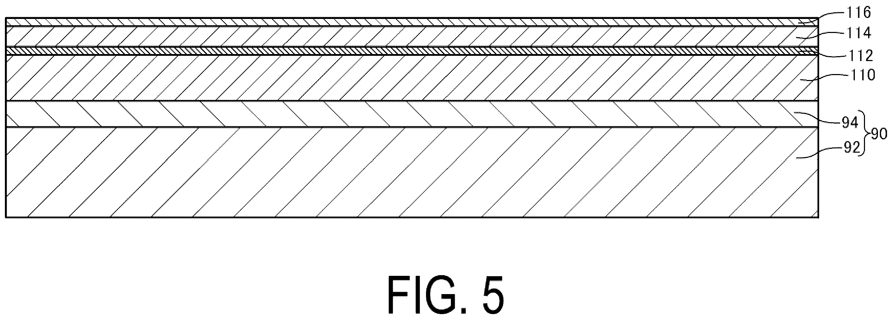

Next, a manufacturing method for the light-emitting device 100 according to the present embodiment will be described with reference to the drawings. FIG. 4 is a flowchart for explaining the manufacturing method for the light-emitting device 100 according to the present embodiment. FIGS. 5 to 14 are cross-sectional views schematically illustrating the manufacturing process of the light-emitting device 100 according to the present embodiment.

As presented in FIGS. 4 and 5, semiconductor layers 110, 112, and 114 are epitaxially grown on a growth substrate 90 in this order (step S1). Examples of the method for epitaxial growth include a metal organic chemical vapor deposition (MOCVD) method and a molecular beam epitaxy (MBE) method.

The growth substrate 90 is a substrate for epitaxially growing the semiconductor layers 110, 112, and 114. The growth substrate 90 includes, for example, a support substrate 92 and a buffer layer 94 provided on the support substrate 92. The support substrate 92 is, for example, a silicon substrate or a sapphire substrate. The buffer layer 94 is, for example, a GaN layer.

Next, a conductive layer 116 is formed on the semiconductor layer 114 (step S2). The conductive layer 116 is formed by, for example, a vacuum vapor deposition method, a sputtering method, or a chemical vapor deposition (CVD) method.

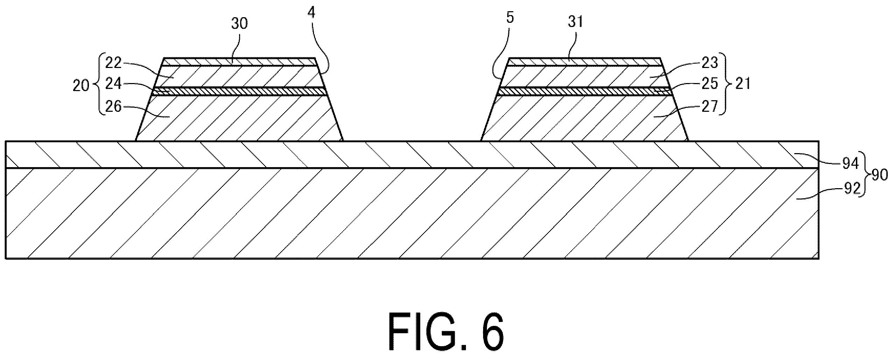

As illustrated in FIG. 6, patterning performed on the conductive layer 116 and the semiconductor layers 110, 112, and 114 (step S3). The patterning is performed by, for example, photolithography and dry etching. The semiconductor layer 110 becomes the second semiconductor layer 26 and the fourth semiconductor layer 27 by being subjected to patterning. The semiconductor layer 112 becomes the first quantum well layer 24 and the second quantum well layer 25 by being subjected to patterning. The semiconductor layer 114 becomes the first semiconductor layer 22 and the third semiconductor layer 23 by being subjected to patterning. The conductive layer 116 becomes the first electrode 30 and the conductive layer 31 by being subjected to patterning.

Through the present process, the first laminate 20 and the second laminate 21 separated from each other can be formed on the growth substrate 90. Furthermore, the first electrode 30 can be formed on the first laminate 20, and the conductive layer 31 can be formed on the second laminate 21.

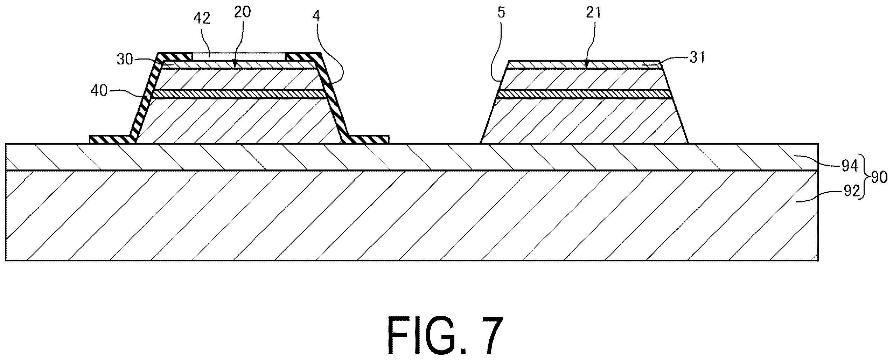

As illustrated in FIG. 7, the insulation layer 40 is formed at the first side surface 4 of the first laminate 20 (step S4). The insulation layer 40 is formed by, for example, a CVD method or an atomic layer deposition (ALD) method. Specifically, after the insulation layer 40 is formed on the entire surface, patterning is performed on the insulation layer 40 to remove the insulation layer 40 formed on the second side surface 5 of the second laminate 21 and the insulation layer 40 formed on the upper surface of the conductive layer 31. Furthermore, the first contact hole 42 is formed by the patterning of the insulation layer 40. The patterning is performed by, for example, photolithography and etching. The insulation layer 40 may be not formed at the second side surface 5 of the second laminate 21 by a liftoff method.

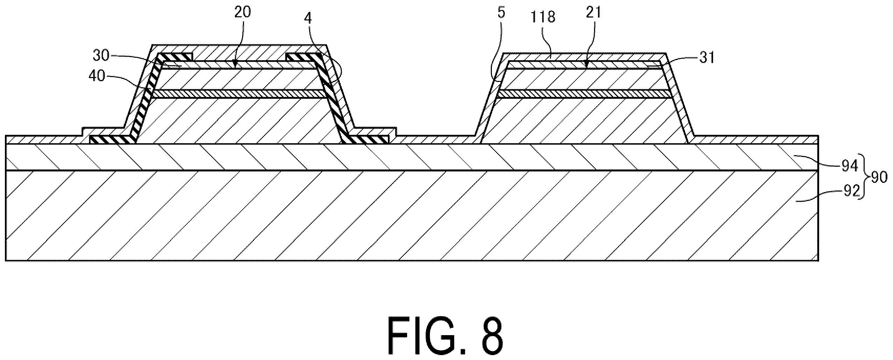

As illustrated in FIG. 8, a metal layer 118 is formed on the insulation layer 40 and the second side surface 5 of the second laminate 21 (step S5). Specifically, the metal layer 118 is formed on the entire surface. The metal layer 118 is formed by, for example, the vacuum vapor deposition method or a sputtering method.

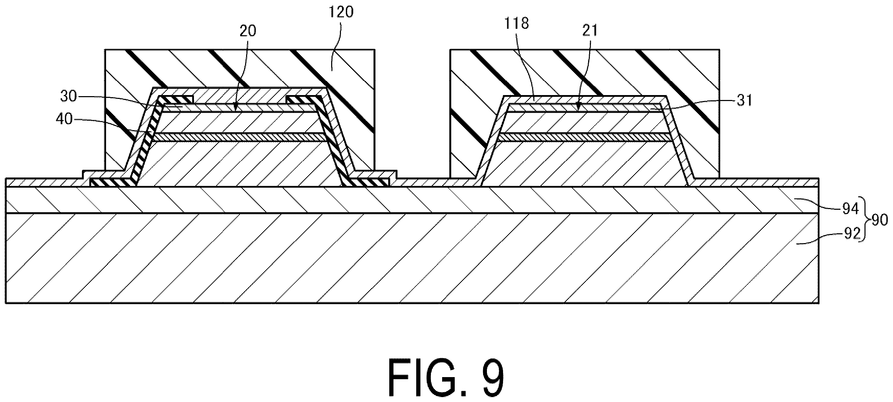

As illustrated in FIG. 9, a resist layer 120 having a predetermined shape is formed so as to cover the first laminate 20 and the second laminate 21 (step S6). The resist layer 120 is formed by application, exposure, and development.

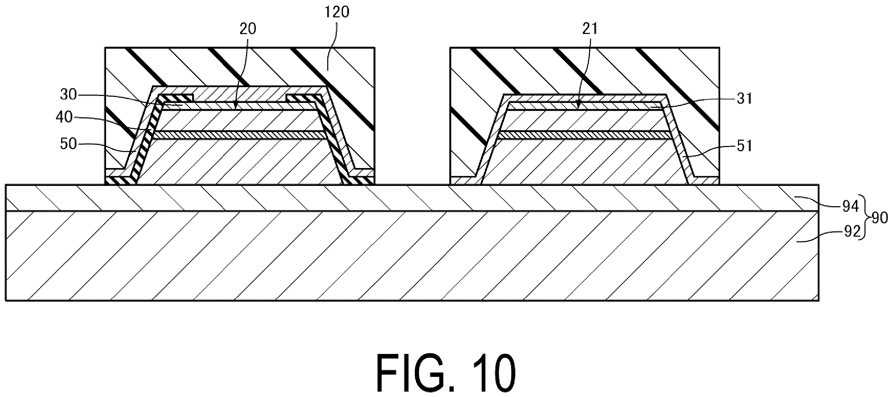

As illustrated in FIG. 10, the metal layer 118 and the insulation layer 40 are dry-etched using the resist layer 120 as a mask (step S7). The metal layer 118 becomes the first metal layer 50 and the second metal layer 51 by being subjected to patterning. Through the present process, the first metal layer 50 can be formed at the insulation layer 40, and the second metal layer 51 can be formed at the second side surface 5 of the second laminate 21.

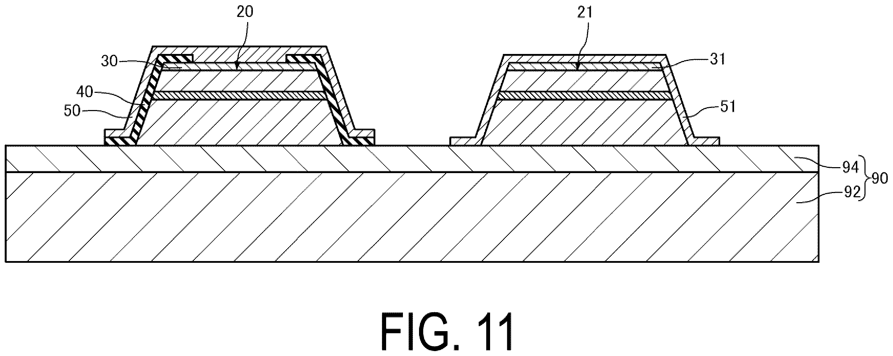

As illustrated in FIG. 11, the resist layer 120 is removed (step S8). A method for removing the resist layer 120 is not particularly limited.

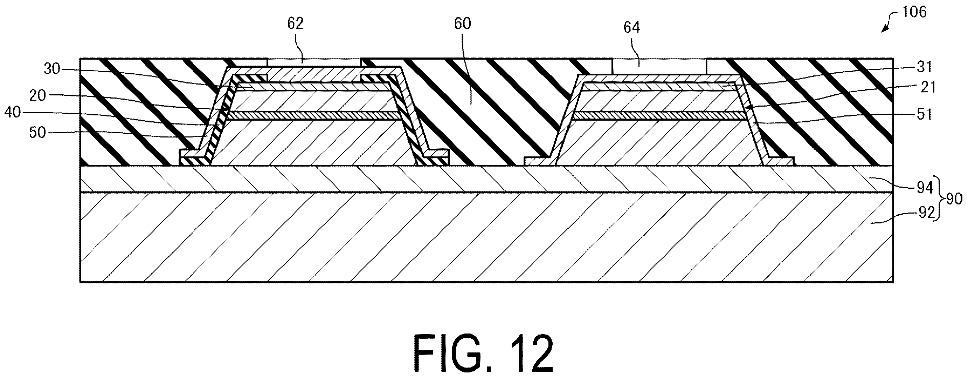

As illustrated in FIG. 12, the protective layer 60 is formed so as to cover the first laminate 20 and the second laminate 21 (step S9). The protective layer 60 is formed by, for example, the CVD method or a spin coating method, and the protective layer 60 is planarized using a chemical mechanical polishing (CMP) device or the like. Thereafter, patterning is performed on the protective layer 60 to form the second contact hole 62 and the third contact hole 64. The patterning is performed by, for example, photolithography and etching.

Through the present process, a structure 106 including the first laminate 20, the second laminate 21, the first electrode 30, the conductive layer 31, the insulation layer 40, the first metal layer 50, the second metal layer 51, the protective layer 60, and the growth substrate 90 can be formed.

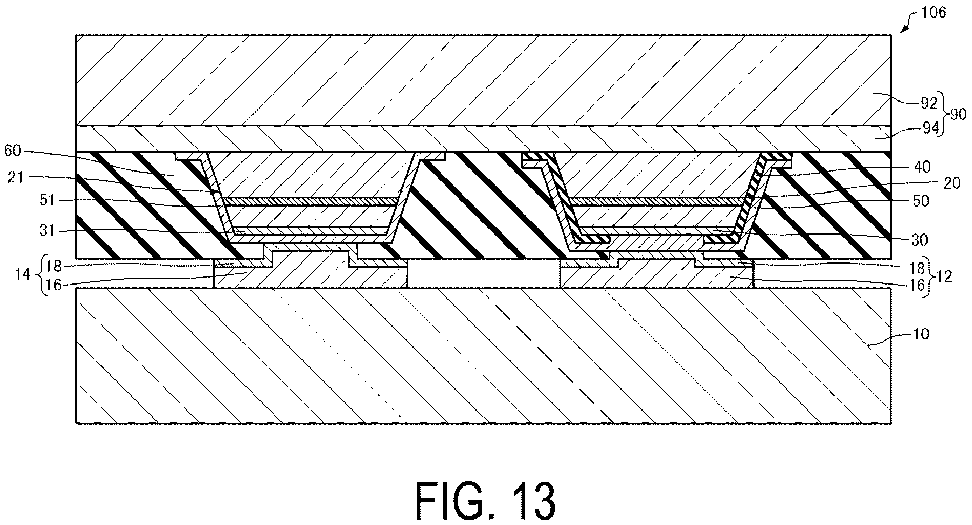

As illustrated in FIG. 13, the structure 106 is bonded to the drive substrate 10 provided with the first pad 12 and the second pad 14 separated from each other such that the first electrode 30 opposes the first pad 12 and the conductive layer 31 opposes the second pad 14 (step S10). Specifically, the structure 106 is junction-down mounted with the first electrode 30 and the conductive layer 31 facing the drive substrate 10 side. In the illustrated example, the first electrode 30 opposes the first pad 12 via the first metal layer 50. The conductive layer 31 opposes the second pad 14 via the second metal layer 51. Examples of the bonding include eutectic bonding, Au-Au bonding, Al-Al bonding, Cu-Cu bonding, and solder bonding. The drive circuit of the drive substrate 10 is formed by ion implantation of impurities into a silicon substrate, formation of a silicon oxide layer, patterning on the pads 12 and 14, and the like.

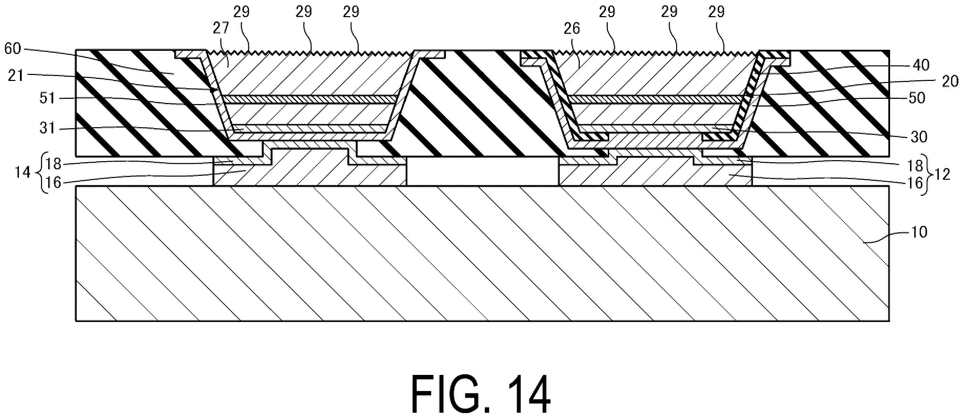

As illustrated in FIG. 14, the growth substrate 90 is removed (step S11). The removal of the growth substrate 90 is performed by, for example, etching, CMP, or the like. Due to this, the first laminate 20 and the second laminate 21 are exposed. Specifically, the second semiconductor layer 26 and the fourth semiconductor layer 27 are exposed.

Next, patterning is performed on the second semiconductor layer 26 and the fourth semiconductor layer 27 to form the plurality of protrusions 29 (step S12). The patterning is performed by, for example, photolithography and etching.

As illustrated in FIG. 1, the second electrode 32 is formed on the first laminate 20 and the second laminate 21 (step S13). Specifically, the second electrode 32 is formed on the second semiconductor layer 26 and the fourth semiconductor layer 27. The second electrode 32 is formed by, for example, the vacuum vapor deposition method or the sputtering method.

Next, the third metal layer 70 is formed on the second electrode 32 via the adhesion layer 72 (step S14). The third metal layer 70 and the adhesion layer 72 are formed by, for example, the sputtering method, the CVD method, the vacuum vapor deposition method, or the plating method.

Next, the translucent member 80 is formed on the second electrode 32 (step S15). The translucent member 80 is formed by, for example, the CVD method. Thereafter, patterning is performed on the translucent member 80 to form the emission surface 82, which is a curved surface. The patterning is performed by, for example, photolithography and etching.

The light-emitting device 100 can be manufactured through the above-described process.

The manufacturing method for the light-emitting device 100 includes forming the first laminate 20 and the second laminate 21 separated from each other at the growth substrate 90 as the first substrate, forming the first electrode 30 at the first laminate 20 and forming the conductive layer 31 at the second laminate 21, forming the insulation layer 40 at the first side surface 4 of the first laminate 20, forming the first metal layer 50 at the insulation layer 40 and forming the second metal layer 51 at the second side surface 5 of the second laminate 21, bonding the structure 106 to the drive substrate 10 as the second substrate provided with the first pad 12 and the second pad 14 separated from each other such that the first electrode 30 opposes the first pad 12 and the conductive layer 31 opposes the second pad 14, removing the growth substrate 90 to expose the first laminate 20 and the second laminate 21, and forming the second electrode 32 at the first laminate 20 and the second laminate 21.

Therefore, in the manufacturing method for the light-emitting device 100, it is not necessary to add a separate manufacturing process for electrical coupling between the second electrode 32 and the second pad 14, and thus the manufacturing process can be shortened.

### 3. Modification Examples of Light-Emitting Device

Next, a light-emitting device according to a modification example of the present embodiment will be described with reference to the drawings. FIG. 15 is a plan view schematically illustrating a light-emitting device 200 according to a modification example of the present embodiment.

Hereinafter, in the light-emitting device 200 according to the modification example of the present embodiment, members having the same functions as constituent members of the light-emitting device 100 according to the above-described embodiment are denoted by the same reference signs, and detailed description thereof will be omitted.

The light-emitting device 100 is provided with only one light-emitting element 102, as illustrated in FIG. 2. Only one coupling portion 104 is provided.

In contrast, the light-emitting device 200 is provided with a plurality of the light-emitting elements 102, as illustrated in FIG. 15. A plurality of coupling portions 104 are provided.

The plurality of light-emitting elements 102 are arrayed in a matrix, for example. In the illustrated example, nine light-emitting elements 102 are provided, but the number thereof is not particularly limited. Although not illustrated, in the plurality of light-emitting elements 102, the second electrodes 32 are continuous with each other. In the plurality of light-emitting elements 102, the second electrode 32 is integrally provided. A plurality of first pads 12 are provided corresponding to the plurality of light-emitting elements 102. A plurality of translucent members 80 are provided corresponding to the plurality of light-emitting elements 102. The plurality of translucent members 80 may constitute a microlens array.

The second laminate 21 of the coupling portion 104 is provided between the first laminate 20 of one light-emitting element 102 and the first laminate 20 of the other light-emitting element 102 of the light-emitting elements 102 adjacent to each other in plan view. In the illustrated example, four coupling portions 104 are provided, but the number thereof is not particularly limited. For example, four corners of one coupling portion 104 are provided with the light-emitting elements 102. Although not illustrated, a plurality of second pads 14 are provided corresponding to the plurality of coupling portions 104.

The light-emitting device 200 is provided with the plurality of light-emitting elements 102 including the first laminate 20, the insulation layer 40, and the first metal layer 50, and the second laminate 21 is provided between the first laminate 20 of one light-emitting element 102 and the first laminate 20 of the other light-emitting element 102 of the light-emitting elements 102 adjacent to each other in plan view. Therefore, the light-emitting device 200 does not require a separate space for forming the second laminate 21. This enables downsizing.

### 4. Projector

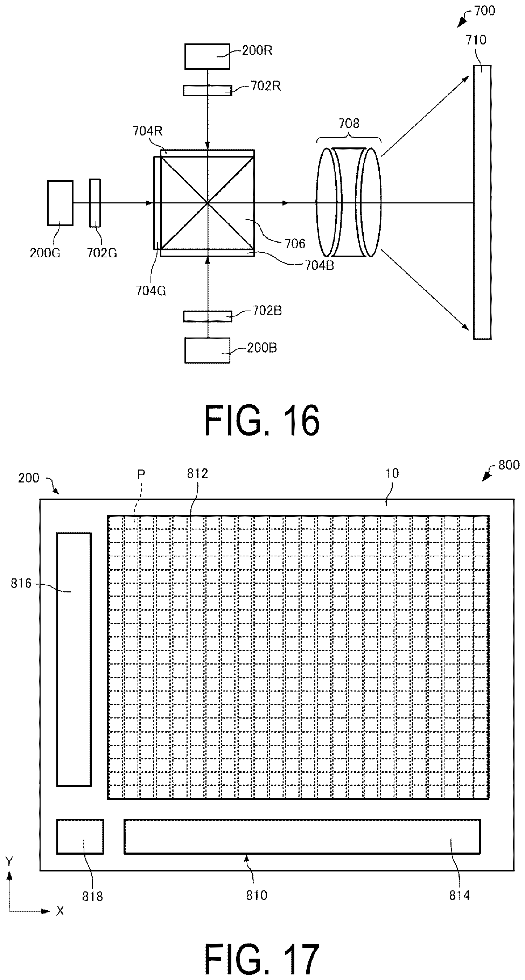

Next, a projector as electronic equipment according to the present embodiment will be described with reference to the drawings. FIG. 16 is a view schematically illustrating a projector 700 according to the present embodiment.

The projector 700 includes the light-emitting device 200 as a light source, for example.

The projector 700 includes a housing not illustrated, and a red light source 200R, a green light source 200G, and a blue light source 200B that are provided in the housing and emit red light, green light, and blue light, respectively. For convenience, FIG. 16 illustrates the red light source 200R, the green light source 200G, and the blue light source 200B in a simplified manner.

The projector 700 further includes a first optical element 702R, a second optical element 702G, a third optical element 702B, a first optical modulation device 704R, a second optical modulation device 704G, a third optical modulation device 704B, and a projection device 708, which are provided in the housing. The first optical modulation device 704R, the second optical modulation device 704G, and the third optical modulation device 704B are, for example, transmissive liquid crystal light valves. The projection device 708 is, for example, a projection lens.

The light emitted from the red light source 200R is incident on the first optical element 702R. The light emitted from the red light source 200R is condensed by the first optical element 702R. The first optical element 702R may have a function other than condensing light. The second optical element 702G and the third optical element 702B may also have a function other than condensing light.

The light condensed by the first optical element 702R is incident on the first optical modulation device 704R. The first optical modulation device 704R modulates the incident light based on image information. Then, the projection device 708 enlarges an image formed by the first optical modulation device 704R and projects the image onto a screen 710.

The light emitted from the green light source 200G is incident on the second optical element 702G. The light emitted from the green light source 200G is condensed by the second optical element 702G.

The light condensed by the second optical element 702G is incident on the second optical modulation device 704G. The second optical modulation device 704G modulates the incident light based on image information. Then, the projection device 708 enlarges an image formed by the second optical modulation device 704G and projects the image onto the screen 710.

The light emitted from the blue light source 200B is incident on the third optical element 702B. The light emitted from the blue light source 200B is condensed by the third optical element 702B.

The light condensed by the third optical element 702B is incident on the third optical modulation device 704B. The third optical modulation device 704B modulates the incident light based on image information. Then, the projection device 708 enlarges the image formed by the third optical modulation device 704B and projects the image onto the screen 710.

The projector 700 further includes a cross dichroic prism 706 that synthesizes, for example, the light emitted from the first optical modulation device 704R, the light emitted from the second optical modulation device 704G, and the light emitted from the third optical modulation device 704B and guides the synthesized light to the projection device 708.

The three rays of color light modulated by the first optical modulation device 704R, the second optical modulation device 704G, and the third optical modulation device 704B are incident on the cross dichroic prism 706. The cross dichroic prism 706 is formed by bonding four right angle prisms, and a dielectric multilayer film that reflects red light and transmits green light and blue light and a dielectric multilayer film that reflects blue light and transmits green light and red light are arranged on an inner surface thereof. The three rays of color light are synthesized by these dielectric multilayer films, and light representing a color image is formed. Then, the synthesized light is projected onto the screen 710 by the projection device 708, and an enlarged image is displayed.

Note that the red light source 200R, the green light source 200G, and the blue light source 200B may directly form a video without using the first optical modulation device 704R, the second optical modulation device 704G, and the third optical modulation device 704B by controlling the light-emitting device 200 in accordance with the image information as a pixel of the video. Then, the projection device 708 may project the video formed by the red light source 200R, the green light source 200G, and the blue light source 200B onto the screen 710 in an enlarged manner.

Although the transmissive liquid crystal light valve is used as the optical modulation device in the above-described example, a light valve other than the liquid crystal light valve may be used, or a reflective light valve may be used. Examples of such a light valve include a reflective liquid crystal light valve and a digital micro mirror device. A configuration of the projection device is changed as appropriate depending on the type of light valve to be used.

The light source can be applied also to a light source device of a scanning type image display device including a scanning means that is an image formation device for displaying an image having a desired size onto a display surface by scanning a screen with light emitted from the light source.

### 5. Display

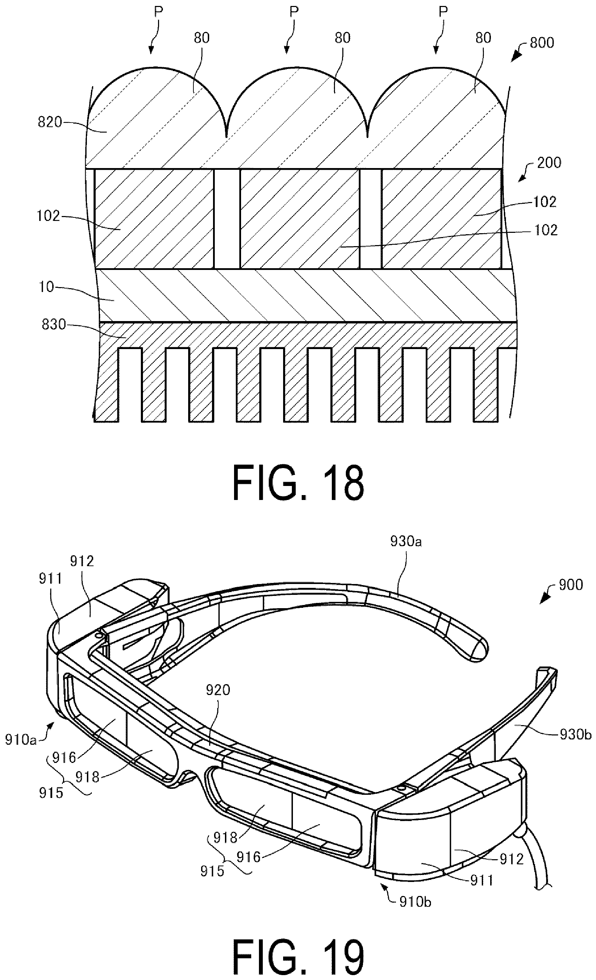

Next, a display as electronic equipment according to the present embodiment will be described with reference to the drawings. FIG. 17 is a plan view schematically illustrating a display 800 according to the present embodiment. FIG. 18 is a cross-sectional view schematically illustrating the display 800 according to the present embodiment. FIG. 17 illustrates an X-axis and a Y-axis as two axes orthogonal to each other. For convenience, FIGS. 17 and 18 illustrate the light-emitting device 200 in a simplified manner.

The display 800 includes the light-emitting device 200 as a light source, for example.

The display 800 is a display device that displays an image. The image includes those only displaying character information. The display 800 is a self-luminous display. As illustrated in FIGS. 17 and 18, the display 800 includes, for example, a drive circuit 810, a lens array 820, and a heatsink 830.

The drive circuit 810 is provided at the drive substrate 10. The drive circuit 810 drives the light-emitting element 102 based on input image information, for example. The drive substrate 10 includes a display region 812, for example. The drive circuit 810 includes a data line drive circuit 814, a scanning line drive circuit 816, and a control circuit 818.

The display region 812 is constituted by a plurality of pixels P. In the illustrated example, the pixels P are arrayed along the X-axis and the Y-axis.

Although not illustrated, the drive substrate 10 is provided with a plurality of scanning lines and a plurality of data lines. For example, the scanning lines extend along the X-axis and the data lines extend along the Y-axis. The scanning lines are coupled to the scanning line drive circuit 816. The data lines are coupled to the data line drive circuit 814. The pixels P are provided corresponding to intersections between the scanning lines and the data lines.

One pixel P includes, for example, one light-emitting element 102, one translucent member 80, and a pixel circuit that is not illustrated. The pixel circuit includes a switching transistor that functions as a switch for the pixel P, a gate of the switching transistor is coupled to the scanning line, and one of a source and a drain is coupled to the data line.

The data line drive circuit 814 and the scanning line drive circuit 816 are circuits that control drive of the light-emitting elements 102 constituting the pixels P. The control circuit 818 controls display of an image.

The control circuit 818 is supplied with image data from an upper level circuit. The control circuit 818 supplies various signals based on the image data to the data line drive circuit 814 and the scanning line drive circuit 816.

When the scanning line is selected by activating the scanning signal by the scanning line drive circuit 816, the switching transistor of the selected pixel P is turned on. At this time, the data line drive circuit 814 supplies the selected pixel P with a data signal from the data line, whereby the light-emitting element 102 of the selected pixel P emits light in accordance with the data signal.

The lens array 820 is constituted by a plurality of translucent members 80. The heatsink 830 is in contact with the drive substrate 10. The material of the heatsink 830 is a metal such as copper or aluminum, for example. The heatsink 830 radiates heat generated by the light-emitting element 102.

### 6. Head-Mounted Display

### 6.1. Overall Configuration

Next, a head-mounted display as electronic equipment according to the present embodiment will be described with reference to the drawings. FIG. 19 is a perspective view schematically illustrating a head-mounted display 900 according to the present embodiment.

As illustrated in FIG. 19, the head-mounted display 900 is a head-mounted display having a glasses-like appearance. The head-mounted display 900 is mounted on the head of a viewer. The viewer is a user who uses the head-mounted display 900. The head-mounted display 900 allows the viewer to visually recognize video light of a virtual image and to visually recognize an external image in a see-through manner.

The head-mounted display 900 includes, for example, a first display unit 910a, a second display unit 910b, a frame 920, a first temple 930a, and a second temple 930b.

The first display unit 910a and the second display unit 910b display images. Specifically, the first display unit 910a displays a virtual image for the right eye of the viewer. The second display unit 910b displays a virtual image for the left eye of the viewer. The display units 910a and 910b include, for example, image formation devices 911 and light guide devices 915.

The image formation device 911 generates image light. The image formation device 911 includes, for example, an optical system such as a light source and a projection device, and an external member 912. The external member 912 accommodates the light source and the projection device.

The light guide devices 915 cover the front of the eyes of the viewer. The light guide device 915 guides the video light formed by the image formation device 911 and allows the viewer to visually recognize external light and the video light in an overlapping manner. Details of the image formation device 911 and the light guide device 915 will be described later.

The frame 920 supports the first display unit 910a and the second display unit 910b. For example, the frame 920 surrounds the display units 910a and 910b. In the illustrated example, the image formation device 911 of the first display unit 910a is attached to one end portion of the frame 920. The image formation device 911 of the second display unit 910b is attached to the other end portion of the frame 920.

The first temple 930a and the second temple 930b extend from the frame 920. In the illustrated example, the first temple 930a extends from one end portion of the frame 920. The second temple 930b extends from the other end portion of the frame 920.

The first temple 930a and the second temple 930b are put on the ears of the viewer when the head-mounted display 900 is worn by the viewer. The head of the viewer is positioned between the temples 930a and 930b.

### 6.2. Image Formation Device and Light Guide Device

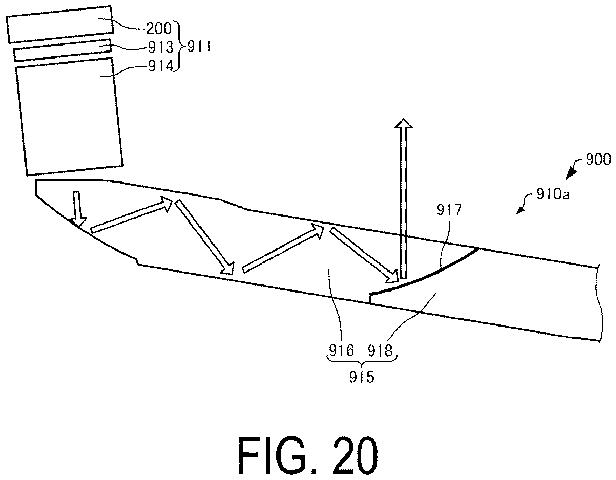

FIG. 20 is a view schematically illustrating the image formation device 911 and the light guide device 915 of the first display unit 910a of the head-mounted display 900. The first display unit 910a and the second display unit 910b have basically the same configuration. Thus, the following description of the first display unit 910a can be applied to the second display unit 910b.

As illustrated in FIG. 20, the image formation device 911 includes, for example, the light-emitting device 200 as a light source, an optical modulation device 913, and a projection device 914 for image formation.

The optical modulation device 913 modulates light incident from the light-emitting device 200 in accordance with image information, and emits video light. The optical modulation device 913 is a transmissive liquid crystal light valve. Note that the light-emitting device 200 may be a self-luminous light-emitting device that emits light in accordance with input image information. In this case, the optical modulation device 913 is not provided.

The projection device 914 projects the video light emitted from the optical modulation device 913 toward the light guide device 915. The projection device 914 is, for example, a projection lens. As the lens constituting the projection device 914, a lens having an axially symmetric surface as a lens surface may be used.

The light guide device 915 is accurately positioned with respect to the projection device 914, for example, by being screwed to a lens barrel of the projection device 914. The light guide device 915 includes, for example, a video light guide member 916 that guides video light and a see-through member 918 for see-through view.

The video light emitted from the projection device 914 is incident on the video light guide member 916. The video light guide member 916 is a prism that guides the video light toward the eyes of the viewer. The video light incident on the video light guide member 916 is repeatedly reflected on the inner surface of the video light guide member 916, and is then reflected by a reflection layer 917 to be emitted from the video light guide member 916. The video light emitted from the video light guide member 916 reaches the eyes of the viewer. The reflection layer 917 is constituted by, for example, a metal or a dielectric multilayer film. The reflection layer 917 may be a half mirror.

The see-through member 918 is adjacent to the video light guide member 916. The see-through member 918 is fixed to the video light guide member 916. The outer surface of the see-through member 918 is continuous with the outer surface of the video light guide member 916, for example. The see-through member 918 causes the viewer to see external light therethrough. The video light guide member 916 also has a function of causing the viewer to see external light therethrough, in addition to the function of guiding video light. The head-mounted display 900 may be configured not to allow the viewer to see external light therethrough.

The light-emitting device according to the embodiment described above can be used for devices other than the projector, the display, and the head-mounted display. The light-emitting device according to the above-described embodiment is used for, for example, indoor and outdoor lighting, a laser printer, a scanner, a sensing device using light, an electronic view finder (EVF), a wearable display such as a smartwatch, an in-vehicle light, and an in-vehicle head-up display.

The embodiment and the modification examples described above are merely examples, and are not intended as limiting to them. For example, each embodiment and each modification example can also be combined together as appropriate.

The present disclosure includes configurations that are substantially identical to the configurations described in the embodiment, for example, configurations with identical functions, methods, and results, or configurations with identical advantages and effects. The present disclosure includes configurations in which non-essential portions of the configurations described in the embodiment are replaced. The present disclosure also includes configurations that achieve the same operations and effects as the configurations described in the embodiments or configurations that can achieve the same advantages. The present disclosure includes configurations in which known techniques are added to the configurations described in the embodiment.

The following content is derived from the embodiments and the modification examples described above.

One aspect of a light-emitting device includes
a substrate,
a first pad provided at the substrate,
a first electrode provided at the first pad,
a first laminate provided at the first electrode,
an insulation layer provided at a side surface of the first laminate,
a first metal layer provided at the insulation layer,
a second pad provided at the substrate and separated from the first pad,
a conductive layer provided at the second pad,
a second laminate provided at the conductive layer,
a second metal layer provided at a side surface of the second laminate, and
a second electrode provided at sides of the first laminate and the second laminate opposite to the substrate and electrically coupled to the second pad via the second metal layer, in which
the first laminate includes
a first semiconductor layer of a first conductivity type,
a second semiconductor layer of a second conductivity type different from the first conductivity type provided between the first semiconductor layer and the second electrode, and
a first quantum well layer provided between the first semiconductor layer and the second semiconductor layer, and
the second laminate includes
a third semiconductor layer of the first conductivity type,
a fourth semiconductor layer of the second conductivity type provided between the third semiconductor layer and the second electrode, and
a second quantum well layer provided between the third semiconductor layer and the fourth semiconductor layer.

According to this light-emitting device, it is possible to shorten the manufacturing process.

In one aspect of the light-emitting device,
the second electrode may be applied with a constant potential.

According to this light-emitting device, the amount of current injected into the first quantum well layer can be adjusted by the potential of the first electrode.

In one aspect of the light-emitting device,
the first laminate may include a tapered portion whose width increases from the first electrode side toward the second electrode side.

According to this light-emitting device, light generated in the first quantum well layer can be reflected toward the second electrode side on the side surface of the tapered portion.

One aspect of the light-emitting device may include
a third metal layer provided at a side of the second electrode opposite to the substrate and having a reflection surface that reflects light generated in the first quantum well layer, in which
the reflection surface may be positioned on an extension of a side surface of the tapered portion.

According to this light-emitting device, it is possible to emit light having a narrower radiation angle while suppressing light transmitted through the second electrode from leaking to the outside.

One aspect of the light-emitting device may include
a translucent member provided at a side of the second electrode opposite to the first laminate and in contact with the reflection surface.

According to this light-emitting device, light transmitted through the translucent member and incident on the reflection surface can be more reliably reflected to the translucent member side on the reflection surface.

In one aspect of the light-emitting device,
a surface of the translucent member opposite to the substrate may be a curved surface.

According to this light-emitting device, the translucent member can function as a lens.

In one aspect of the light-emitting device,
the insulation layer may have translucency.

According to this light-emitting device, even when light generated in the first quantum well layer is transmitted through an insulation layer having translucency, the light transmitted through the insulation layer can be reflected toward the first laminate side by the first metal layer.

In one aspect of the light-emitting device,
a plurality of light-emitting elements including the first laminate, the insulation layer, and the first metal layer may be provided, and
the second laminate may be provided between the first laminate of one of the light-emitting elements and the first laminate of another of the light-emitting elements of the light-emitting elements adjacent to each other in plan view.

According to this light-emitting device, it is not necessary to separately provide a space for forming the second laminate.

One aspect of electronic equipment includes
one aspect of the light-emitting device.

One aspect of a manufacturing method for a light-emitting device includes:
forming a first laminate and a second laminate separated from each other on a first substrate,
forming a first electrode on the first laminate and forming a conductive layer on the second laminate,
forming an insulation layer on a side surface of the first laminate,
forming a first metal layer on the insulation layer and forming a second metal layer on a side surface of the second laminate,
bonding a structure including the first substrate, the first laminate, the second laminate, the first electrode, the conductive layer, the insulation layer, the first metal layer, and the second metal layer to a second substrate provided with a first pad and a second pad separated from each other such that the first electrode opposes the first pad and the conductive layer opposes the second pad,
removing the first substrate to expose the first laminate and the second laminate, and
forming a second electrode on the first laminate and the second laminate, in which
the first laminate includes
a first semiconductor layer of a first conductivity type,
a second semiconductor layer of a second conductivity type different from the first conductivity type provided between the first semiconductor layer and the second electrode, and
a first quantum well layer between the first semiconductor layer and the second semiconductor layer, and
the second laminate includes
a third semiconductor layer of the first conductivity type,
a fourth semiconductor layer of the second conductivity type provided between the third semiconductor layer and the second electrode, and
a second quantum well layer between the third semiconductor layer and the fourth semiconductor layer.

According to this manufacturing method for a light-emitting device, it is possible to shorten the manufacturing process.

## Claims

1. A light-emitting device comprising:
a substrate;
a first laminate;
a first electrode provided between the first laminate and the substrate;
a first pad provided between the first electrode and the substrate;
an insulation layer provided on a side surface of the first laminate;
a first metal layer provided on the insulation layer;
a second laminate;
a conductive layer provided between the second laminate and the substrate;
a second pad provided between the conductive layer and the substrate, and separated from the first pad;
a second metal layer provided on a side surface of the second laminate; and
a second electrode provided on sides of the first laminate and the second laminate opposite to the substrate and electrically coupled to the second pad via the second metal layer; wherein
the first laminate includes
a first semiconductor layer of a first conductivity type,
a second semiconductor layer of a second conductivity type different from the first conductivity type provided between the first semiconductor layer and the second electrode, and
a first quantum well layer provided between the first semiconductor layer and the second semiconductor layer, and
the second laminate includes
a third semiconductor layer of the first conductivity type,
a fourth semiconductor layer of the second conductivity type provided between the third semiconductor layer and the second electrode, and
a second quantum well layer provided between the third semiconductor layer and the fourth semiconductor layer.

2. The light-emitting device according to claim 1, wherein
the second electrode is applied with a constant potential.

3. The light-emitting device according to claim 1, wherein
the first laminate includes a tapered portion whose width increases from the first electrode side toward the second electrode side.

4. The light-emitting device according to claim 3 comprising:
a third metal layer provided at a side of the second electrode opposite to the substrate and having a reflection surface that reflects light generated in the first quantum well layer, wherein
the reflection surface is positioned on an extension of a side surface of the tapered portion.

5. The light-emitting device according to claim 4 comprising:
a translucent member provided at a side of the second electrode opposite to the first laminate and in contact with the reflection surface.

6. The light-emitting device according to claim 5, wherein
a surface of the translucent member opposite to the substrate is a curved surface.

7. The light-emitting device according to claim 1, wherein
the insulation layer has translucency.

8. The light-emitting device according to claim 1, wherein
a plurality of light-emitting elements including the first laminate, the insulation layer, and the first metal layer are provided, and
the second laminate is provided between the first laminate of one of the light-emitting elements and the first laminate of another of the light-emitting elements of the light-emitting elements adjacent to each other in plan view.

9. Electronic equipment comprising the light-emitting device according to claim 1.

10. A manufacturing method for a light-emitting device, the manufacturing method comprising:
forming a first laminate and a second laminate separated from each other on a first substrate;
forming a first electrode on the first laminate and forming a conductive layer on the second laminate;
forming an insulation layer on a side surface of the first laminate;
forming a first metal layer on the insulation layer and forming a second metal layer on a side surface of the second laminate;
bonding a structure including the first substrate, the first laminate, the second laminate, the first electrode, the conductive layer, the insulation layer, the first metal layer, and the second metal layer to a second substrate provided with a first pad and a second pad separated from each other such that the first electrode opposes the first pad and the conductive layer opposes the second pad;
removing the first substrate to expose the first laminate and the second laminate; and
forming a second electrode on the first laminate and the second laminate; wherein
the first laminate includes
a first semiconductor layer of a first conductivity type,
a second semiconductor layer of a second conductivity type different from the first conductivity type provided between the first semiconductor layer and the second electrode, and
a first quantum well layer between the first semiconductor layer and the second semiconductor layer, and
the second laminate includes
a third semiconductor layer of the first conductivity type,
a fourth semiconductor layer of the second conductivity type provided between the third semiconductor layer and the second electrode, and
a second quantum well layer between the third semiconductor layer and the fourth semiconductor layer.
